# Europäisches Patentamt
## European Patent Office
## Office européen des brevets

(19)

(11) Publication number: **0 049 590**
**B1**

(12)

# EUROPEAN PATENT SPECIFICATION

(45) Date of publication of patent specification: **11.02.87**

(51) Int. Cl.⁴: **H 03 K 4/69,** H 03 K 6/02

(21) Application number: **81304456.7**

(22) Date of filing: **28.09.81**

(54) Cathode ray tube beam deflection amplifier system.

(30) Priority: **02.10.80 US 193236**

(43) Date of publication of application:
**14.04.82 Bulletin 82/15**

(45) Publication of the grant of the patent:
**11.02.87 Bulletin 87/07**

(84) Designated Contracting States:
**DE FR GB IT**

(56) Références cited:
**FR-A-2 210 050**
**GB-A-1 270 342**
**US-A-3 774 068**
**US-A-3 784 857**
**US-A-3 786 303**
**US-A-3 816 792**

**"Elektronik ohne Ballast", Otto Liman, Franzis
Verlag, 1978, München, pages 124-125,
fig.6.52,6.54**

(73) Proprietor: **SPERRY CORPORATION
1290, Avenue of the Americas
New York, N.Y. 10019 (US)**

(72) Inventor: **Spilsbury, Thomas William
2421 W. Kathleen Road
Phoenix Arizona 85023 (US)**

(74) Representative: **Singleton, Jeffrey
ERIC POTTER & CLARKSON 27 South Street
Reading Berkshire, RG1 4QU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to cathode ray beam deflection systems and more particularly to beam deflection amplifier systems employed in electromagnetic deflection systems.

One prior art deflection amplifier system of interest with respect to the present invention is disclosed in U.S. Patent Specification No. 3,816,792, this system including a differential input amplifier stage and a push-pull current controlling output stage which drives the deflection coil of the display system. A sampling resistor is connected in series with the beam deflection coil to provide a negative feed back voltage proportional to coil current for use in promoting linear operation of the system. One terminal of a capacitor is connected to the end of the beam deflection coil coupled to the input amplifier output terminal, while the other terminal of the capacitor is connected through a bidirectional switch to a voltage source. The bidirectional switch consists of a transistor and a diode connected in parallel, each constituting a respective half of the switch and operative in respective halves of the cycle of resonant oscillation which occurs during the resonant retrace interval. When the deflection amplifier system is operating in the linear mode, the bidirectional switch is non-conducting and, therefore, the capacitor is effectively disconnected from the deflection coil. In the non-linear mode, the bidirectional switch functions to connect the capacitor conductively with the beam deflection coil; simultaneously, a second switch effectively disconnects the coil-capacitor circuit from the input amplifier, whereby resonant current flow occurs between the beam deflection coil and the capacitor to effect the desired rapid, energy-saving retrace. Other prior art of interest is disclosed in U.S. Patent Specification No. 3,786,303. These prior art configurations, though they accomplish their objectives in an entirely satisfactory manner, have a common limiting defect in that the fly-back capacitor shunts the deflection coil. This fact limits the operating band width of the circuit, increases the level of power dissipation, and increases the chances of unstable operation. While the arrangement of U.S. Patent Specification No. 3,816,792 advantageously switches the fly-back capacitor out of the circuit cyclically, complexity and part count were undesirably increased and, of course, the shunting effect of the capacitor is not fully removed.

A low voltage vertical deflection system which does not have the fly-back capacitor shunting the deflection coil is disclosed in Figure 8 of U.S.—A—3,774,068, on which the preamble of claim 1 is based.

In GB—A—1,270,342 there is disclosed a push-pull beam deflection circuit for providing a linear high speed sweep signal which utilises a diode for isolating a deflection coil from its driving amplifier after the amplifier is deenergised.

According to the present invention there is provided a cathode ray tube electron beam horizontal deflection control system comprising deflection coil means and fly-back capacitor means coupled to the deflection coil means, preamplifier means having an input terminal and first and second output terminals, first amplifier means having input and output terminals with one of the output terminals being connected to a first voltage supply means, and the input terminal being coupled to the first output terminal of the preamplifier for amplifying the current received therefrom, second amplifier means having input and output terminals with one of the output terminals being connected to a second voltage supply means, and the input terminal being coupled to the second output terminal of the preamplifier for amplifying the current received therefrom, fly-back diode means having first and second terminals, the first terminal being coupled to the first amplifier output terminal for unidirectionally conducting current received from the amplifier output terminal to the fly-back diode second terminal, diode means having first and second terminals, the first terminal being coupled to the first voltage supply means and the second terminal being coupled to the output terminal of the first amplifier means for unidirectionally coupling current to the first voltage supply from the diode means second terminal, the fly-back capacitor means being coupled in series relationship with the diode means and in shunt relationship with the fly-back diode means, the capacitor means having a terminal directly coupled in common with the deflection coil means and the second terminal of the fly-back diode means, the system having energised linear stroke writing and non-linear resonant fly-back operating modes, and means for applying an input sweep signal representative of a desired motion of the beam to the input terminal of the preamplifier during the linear mode of operation, characterised in that there is provided switching means responsive to an applied fly-back drive signal for coupling the second amplifier output terminal with the fly-back diode means second terminal in the linear mode of operation, and for decoupling the second amplifier output terminal from the fly-back diode means in the subsequent non-linear mode of operation, the switching means being in the form of a first field effect transistor having source, drain, and gate electrodes the source electrode being coupled to the output of the second amplifier and the drain electrode being coupled to the second terminal of the fly-back diode and in that there is further provided a transformer having primary and secondary windings a first series circuit coupled between the gate and source electrodes of the first transistor and comprising a Zener diode and the secondary winding and of the transformer and a first resistor coupled between the junction of the gate electrode and the Zener diode and a third power supply means ($+V_2$), and a second series circuit coupled between the third power supply means ($+V_2$) and a ground terminal and comprising a second resistor connected between the third power supply means $(+V_2)$ and the transformer primary winding and a second transistor having its emitter coupled to the ground terminal, its collector coupled to the transformer primary winding and its base coupled to receive the fly-back drive pulses, whereby the first transistor means will substantially cease conduction in response to the fly-back drive pulses applied to the second transistor means.

The present invention provides an efficient and a compact cathode ray beam deflection coil excitation system of simplified nature. As in the aforementioned prior art circuit, a preamplifier stage is provided along with a current amplifying output stage which applies excitation of the beam deflection coil. In the present invention, however, the fly-back system is now integrated directly within the current amplifier stage. As will be further described, when operating in the non-linear resonant mode, a portion of that stage that is conducting current to the deflection coil will be abruptly decoupled from the deflection coil via a switch, such that the energy stored within the deflection coil will resonantly discharge through a series connected capacitor to a power supply being used to return the fly-back current, thereby reducing the number of parts and improving performance with respect to the prior art. This integration also provides a hybrid deflection control system capable of both raster or stroke presentation.

A cathode ray beam deflection system in accordance with the present invention will now be described in greater detail, by way of example, with reference to the accompanying drawings, in which:—

Figure 1 is a wiring diagram of the system showing its electrical components and their interconnections, and

Figures 2a to 2e are graphs useful in explaining the operation of the system of Figure 1.

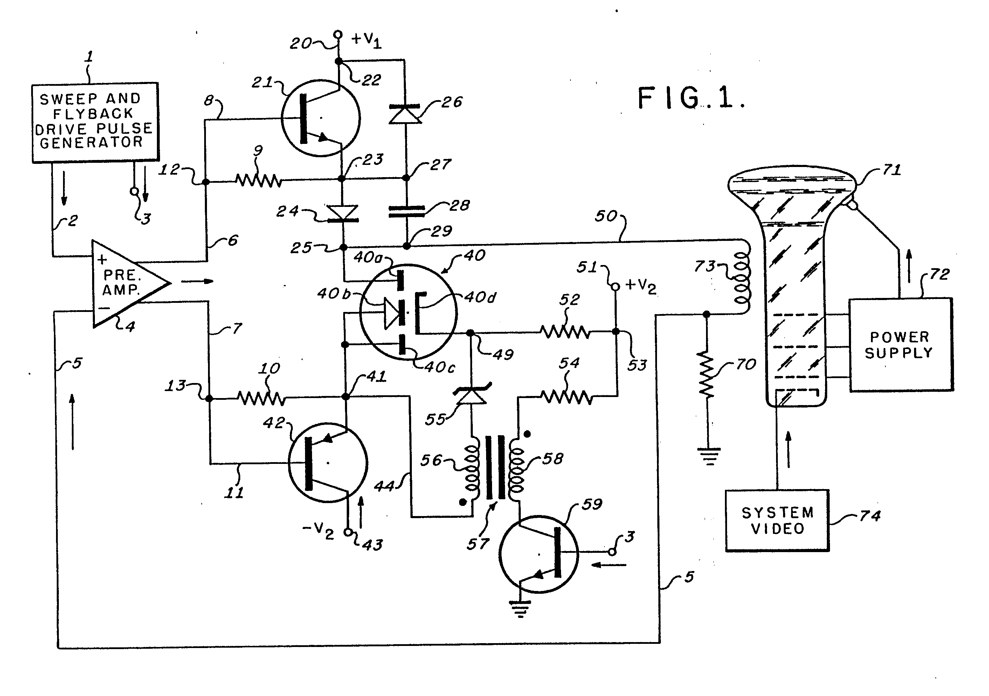

Figure 1 shows a cathode ray display tube 71 having a deflection coil 73 and being supplied in the usual manner from a suitable anode voltage power supply 72. The display tube 71 includes a cathode which may be fed with video signals from a video source 74. The power supply 72 is additionally arranged to activate at least one prefocussing or control grid and a focussing electrode, in the usual manner.

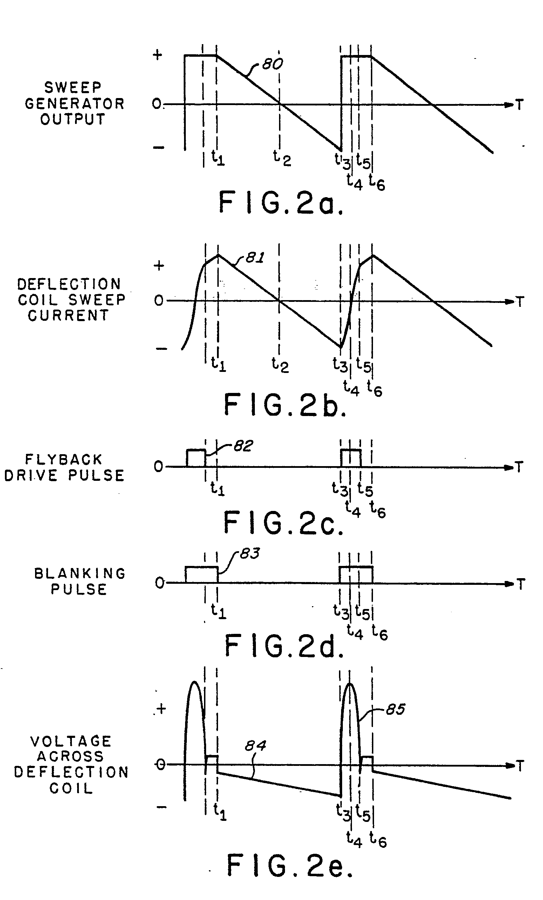

A deflection sweep wave generator 1 containing an internal fly-back drive pulse generator supplies the sweep wave voltage 80 of Figure 2a via a lead 2 to one input of a differential preamplifier 4, and fly-back drive synchronising pulses such as those at 82 of Figure 2c, which control the timing of the sweep wave 80 and appear at a terminal 3 for timing the operation of a transistor 59. The sweep generator 1 also supplies the electron beam blanking pulses 83 of Figure 2d for blanking the flow of beam current in the time $t_3$ to $t_6$ indicated in Figure 2d when it is desired to prevent the beam from writing on the cathode ray tube phosphor. It will be understood that the power supply 72 and apparatus for forming the blanking pulses form no essential part of the present invention so that they need not be discussed in any further detail.

One end of the deflection coil 73 is coupled to ground through a current sampling resistor 70 which provides a voltage proportional to current flowing through the deflection coil 73 and which voltage is fed back as a negative feed back signal via a lead 5 to a second input of the preamplifier 4, the inputs on leads 2 and 5 being poled as shown in Figure 1.

A first output terminal of the preamplifier 4 is coupled via a lead 6 to a junction 12 where there is found a branching circuit via a lead 8 to the base of a transistor 21 and a resistor 9 to a junction 23 and thence to the emitter of the transistor 21. The collector of the transistor 21 is coupled through junction 22 to a voltage source $+V_1$ at a terminal 20. A diode 26 is connected between a junction 22 and a junction 27 to the junction 23. Connections are also made from the junctions 23 and 27 by a diode 24, which will be referred to as the fly-back diode, and a junction 25; and by a capacitor 28, which will be referred to as the fly-back capacitor, and a junction 29 to a lead 50 for supply of deflection current to the coil 73.

A second output terminal of the preamplifier 4 is coupled by a lead 7 to a junction 13 where there is found a branching circuit via a lead 11 to the base of a transistor 42, and a resistor 10 to a junction 41 and thence to the emitter of transistor 42. The collector of transistor 42 is coupled at a terminal 3 to a source of voltage $-V_2$.

The junction 41 is coupled to the source electrode 40c of a field effect transistor 40 and also to its substrate electrode 40b, while junction 25 is coupled to the drain electrode 40a thereof. The gate electrode 40d of the transistor 40 is connected through a junction 49, resistor 52, and junction 53 to a source of voltage $+V_2$ at a terminal 51. The transistor 40 is of the n-channel, metal-oxide-semiconductor field effect type. It is a temperature stable, enhancement mode, metal-oxide-semiconductor field effect transistor (MOSFET), having the source tied to the substrate, and is obtainable, for example, from International Rectifier's Semiconductor Division, 233 Kansas Street, El Segundo, California 90245.

The gate electrode 40d of the transistor 40 is also connected through the junction 49, a Zener diode 55, a first winding 56 of a transformer 57 (poled as shown), and a lead 44 to the junction 41 of the emitter of transistor 42. The circuit is completed through the resistor 52, junction 53, resistor 54, and the second transformer winding 58 (poled as shown). As noted, fly-back drive pulses applied to the terminal 3 from the sweep and fly-back drive pulse generator 1 are supplied to the base terminal of transistor 59 which is coupled to the terminal 3; the collector of the transistor 59 is coupled to the end of the winding 58 opposite resistor 54, while its emitter is grounded.

During the cathode ray beam sweep time $t_1$ to $t_3$

of wave 80 of Figure 2a, the transistor 59 is held non-conducting by the absence of a fly-back drive pulse 82 of Figure 2c on terminal 3. The transistor 40, however, is biased into its conducting state by the positive gate-to-source electrode voltage which consequently develops across the Zener diode 55, due to the small bias current flowing from the $+V_2$ voltage source at terminal 51 through the resistor 52, Zener diode 55, transformer secondary 56, and transistopr 42, to the $-V_2$ power supply terminal 43. The secondary 56 of the pulse transformer 57 behaves as a d.c. short circuit. As long as the transistor 40 conducts, the invention operates as a conventional linear, or stroke, push-pull amplifier. The effects of the forward voltage drop across the fly-back diode 24 and transistor 59 are compensated in a conventional manner by setting up appropriate bias voltages in the output stage of the preamplifier 4, the output signals therefrom being in phase but displaced from each other by the aforesaid bias voltages. As a result, a minimum of crossover distortion occurs at the output 50 of the amplifier system.

At the start of time $t_1$, the waveform 80 is positive with respect to ground, and the transistor 21 is on, amplifying the sweep signal received from the preamplifier 4 bia the lead 6, and permitting current to flow from the $+V_1$ power supply at terminal 20 through the transistor 21, diode 24, deflection coil 73 and resistor 70 to ground. The transistor 42 is biased to conduct current when the sweep generator output signal received from the preamplifier 4 via lead 7 approaches zero volts at time $t_2$, from the $-V_2$ power supply at terminal 43, through transistor 40, deflection coil 73, and resistor 70, to ground.

At the start of the fly-back time $t_3$, deflection current is flowing through the transistor 42. The transistor 59 is made to conduct by a fly-back drive pulse applied at terminal 3 to its base electrode. The conduction of transistor 59 causes a voltage drop across the primary winding 58 of transformer 57 so that a corresponding rapid voltage change obtains across the transformer winding 56. This latter impulse pulls the gate-to-source voltage of the transistor 40 negative causing it to become reverse biased, abruptly ending conduction therein. In this manner, the current path of the deflection wave 81 changes at time $t_3$ and a new current path is used. The current in the coil 73 can no longer flow through the transistor 42 and instead flows through the fly-back capacitor 28 and diode 26 into the supply of $+V_1$ voltage at terminal 20.

The sudden change in current generates a positive voltage pulse according to the equation:

$$V = L\,\frac{di}{dt}$$

where L = the deflection coil inductance,
　　　　V = the voltage on the coil,
　　di/dt = the change in deflection coil current with time.

Consequently, a half cycle 85 (Figure 2e) of a resonant sinusoidal oscillation is initiated in the effective inductance of the deflection coil 73 together with the capacitance of the fly-back capacitor 28, and appears as a fly-back pulse on lead 50.

As the current shown by waveform 81 in Figure 2b flows through the deflection coil 73, it will decrease in amplitude from the negative maximum reached at time $t_3$, until it falls to zero volts at time $t_4$, in correspondence with the fly-back pulse 85 peak, and reverses, thereby becoming positive. Reverse current will now flow from the $+V_1$ power supply at terminal 20 and through the transistor 21 and the fly-back capacitor 28 until the voltage across the latter rises to a point where it will forward bias the diode 24 into conduction. The diode 24 thus acts as a clamping diode and prevents the current from ringing negatively. At this time, $t_5$, the transistor 59 is turned off by the ending of pulse 82 and the transistor 40 is again biased into conduction. The operation of the invention becomes linear again, comparing the inputs on leads 2 and 5 to correct for any error between the voltage at the input of the preamplifier 4 on lead 2 across the sampling resistor 70 in the manner of a conventional amplifier using negative feed back. As long as the transistor 40 remains conducting, the invention behaves as a linear or stroke type of amplifier. Thus, the invention desirably operates to convert the input drive voltage on the lead 2 to a proportional current flowing through the deflection coil 73.

It is seen that the invention provides a simplified electron beam deflection control system of compact nature which permits hybrid operation with a reduced number of parts. The fly-back capacitor 28 does not shunt the yoke inductance 73 during linear operation so that the operating bandwidth is increased and the cathode ray trace is sharper. The fly-back capacitor 28 is also desirably not switched in and out of circuit thus not requiring the additional switching circuits of the prior art. Furthermore, stability is improved because the fly-back capacitor 28 is no longer grounded, eliminating the potential of a typical emitter-follower parasitic oscillation problem. Quicker recovery after the fly-back interval is achieved without the use of appreciably higher power.

## Claims

1. A cathode ray tube electron beam horizontal deflection control system comprising deflection coil means (73) and fly-back capacitor means (28) coupled to the deflection coil means, preamplifier means (4) having an input terminal and first and second output terminals, first amplifier means (21) having input and output terminals with one of the output terminals being connected to a first voltage supply means $(+V_1)$, and the input terminal being coupled to the first output terminal of the preamplifier for amplifying the current received therefrom, second amplifier means (42) having input and output terminals with one of the output terminals being connected to a second voltage supply means $(-V_2)$, and the input terminal being coupled to the second output terminal of the preamplifier for amplifying the current received therefrom, fly-back diode means (24) having first and second terminals, the first terminal being coupled to the first amplifier output terminal for unidirectionally conducting current received from the amplifier output terminal to the fly-back diode second terminal, diode means (26) having first and second terminals, the first terminal being coupled to the first voltage supply means and the second terminal being coupled to the output terminal of the first amplifier means for unidirectionally coupling current to the first voltage supply from the diode means second terminal, the fly-back capacitor means being coupled in series relationship with the diode means (26) and in shunt relationship with the fly-back diode means (24), the capacitor means having a terminal directly coupled in common with the deflection coil means and the second terminal of the fly-back diode means, the system having linear stroke writing and non-linear resonant fly-back operating modes, and means for applying an input sweep signal (2) representative of a desired motion of the beam to the input terminal of the preamplifier (4) during the linear mode of operation, characterised in that there is provided switching means responsive to an applied fly-back drive signal (3) for coupling the second amplifier (42) output terminal with the fly-back diode means (24) second terminal in the linear mode of operation, and for decoupling the second amplifier output terminal from the fly-back diode means in the subsequent non-linear mode of operation, the switching means being in the form of a first field effect transistor (40) having source, drain, and gate electrodes (40c, 40a, 40d), the source electrode (40c) being coupled to the output of the second amplifier (42), and the drain electrode (40a) being coupled to the second terminal of the fly-back diode (24), and in that there is further provided a transformer (57) having primary and secondary windings (58, 56) a first series circuit coupled between the gate and source electrodes (40d, 40c) of the first transistor (40) and comprising a Zener diode (55) and the secondary winding (56) and of the transformer (57), and a first resistor (52) coupled between the junction of the gate electrode (40d) and the Zener diode (55) and a third power supply means $(+V_2)$, and a second series circuit coupled between the third power supply means $(+V_2)$ and a ground terminal and comprising a second resistor (54) connected between the third power supply means $(+V_2)$ and the transformer primary winding (58), and a second transistor (59) having its emitter coupled to the ground terminal, its collector coupled to the transformer primary winding (58), and its base coupled to receive the fly-back drive pulses, whereby the first transistor means (40) will substantially cease conduction in response to the fly-back drive pulses applied to the second transistor means (59).

2. A system according to claim 1, characterised in that the first amplifier means comprises a third transistor (21) having a base coupled to the first output terminal of the preamplifier means (4), a collector coupled to the first voltage supply means $(+V_1)$ and the emitter coupled to the first terminal of the fly-back diode means (24), and in that the second amplifier comprises a fourth transistor (42) having a base coupled to the second output of the preamplifier (4), an emitter coupled to the first transistor (40) and a collector coupled to the second voltage supply means $(-V_2)$, the third transistor (21), and the fourth transistor (42) being adapted for push-pull operation in the linear stroke-writing mode.

3. A system according to claim 1 or 2, characterised in that the preamplifier means comprises a differential amplifier (4) having first and second inputs, the first input being responsive to the sweep signal and an independently generated character writing signal, and further comprising an impedance (70) connected in series with the deflection coil (73) for providing a voltage representative of the current flowing therethrough to be fed back to the second input of the differential amplifier for comparison with the sweep signal input to derive an error signal equal to the difference between the input and feedback signals for controlling the current supplied by the preamplifier means in the linear mode.

4. A system according to claim 2 and any claim appended thereto, characterised in that the third and fourth transistors (21, 42) are selected to be complementary symmetrical, the first and third voltage supply means $(+V_1, +V_2)$ have a positive polarity, and the second voltage supply means $(-V_2)$ has a negative polarity.

## Revendications

1. Ensemble de commande de déviation horizontale de faisceaux électroniques de tubes à rayons cathodiques, comprenant une bobine de déviation (73) et un condensateur de retour de spot (28) couplé à la bobine de déviation, un préamplificateur (4) ayant une borne d'entrée et une première et une seconde borne de sortie, un premier amplificateur (21) ayant des bornes d'entrée et de sortie, une des bornes de sortie étant connectée à une première alimentation en ten-

sion ($+V_1$) et la borne d'entrée étant couplée à la première borne de sortie du préamplificateur afin que le courant reçu de celui-ci soit amplifié, un second amplificateur (42) ayant des bornes d'entrée et de sortie, l'une des bornes de sortie étant connectée à une seconde alimentation en tension ($-V_2$) et la borne d'entrée étant couplée à la seconde borne de sortie du préamplificateur afin que le courant reçu à partir de celui-ci soit amplifié, une diode de retour de spot (24) ayant une première et une seconde borne, sa première borne étant couplée à la borne de sortie du premier amplificateur afin qu'elle conduise le courant reçu de la borne de sortie de l'amplificateur unidirectionnellement vers la seconde borne de la diode de retour de spot, une diode (26) ayant une première et une seconde borne, la première borne étant couplée à la première alimentation en tension et la seconde borne étant couplée à la borne de sortie du premier amplificateur afin que du courant soit couplé unidirectionnellement à la première alimentation à partir de la seconde borne de la diode, le condensateur de retour de spot étant couplé en série avec la diode (26) et en shunt avec la diode de retour de spot (24), le condensateur ayant une borne directement couplée en commun avec la bobine de déviation et la seconde borne de la diode de retour de spot, l'ensemble ayant des modes de fonctionnement à retour de spot non linéaires à la résonance et d'écriture vectorielle linéaire et un dispositif destiné à appliquer un signal de balayage d'entrée (2) représentatif d'un déplacement voulu du faisceau, à la borne d'entrée du préamplificateur (4) pendant le mode linéaire de fonctionnement, caractérisé en ce qu'il comporte un dispositif de commutation commandé par un signal appliqué (3) de commande de retour de spot et destiné à coupler la borne de sortie du second amplificateur (42) à la seconde borne de la diode de retour de spot (24) en mode linéaire de fonctionnement, et à découpler la borne de sortie du second amplificateur de la diode de retour de spot dans le mode non linéaire suivant de fonctionnement, le dispositif de commutation étant sous forme d'un premier transistor à effet de champ (40) ayant des électrodes de source, de drain et de grille (40c, 40a, 40d), la source (40c) étant couplée à la sortie du second amplificateur (42) et le drain (40a) étant couplé à la seconde borne de la diode de retour de spot (24), et en ce qu'il comprend en outre un transformateur (57) ayant un primaire et un secondaire (58, 56), un premier circuit série couplé entre la grille et la source (40d, 40c) du premier transistor (40) et comprenant une diode de Zener (55) et le secondaire (56) du transformateur (57), et une première résistance (52) couplée entre la connexion de la grille (40d) et la diode de Zener (55) et une troisième alimentation ($+V_2$), et un second circuit série couplé entre la troisième alimentation ($+V_2$) et une borne de masse et comprenant une seconde résistance (54) connectée entre la troisième alimentation ($+V_2$) et le primaire du transformateur (58), et un second transistor (59) ayant son émetteur relié à la borne de masse, son collecteur relié au primaire (58) du transformateur, et sa base reliée de manière qu'elle reçoive les impulsions de commande de retour de spot, si bien que le premier transistor (40) cesse pratiquement de conduire sous l'action des impulsions de commande de retour de spot appliquées au second transistor (59).

2. Ensemble selon la revendication 1, caractérisé en ce que le premier amplificateur comporte un troisième transistor (21) ayant une base reliée à la première borne de sortie du préamplificateur (4), un collecteur couplé à la première alimentation en tension ($+V_1$) et l'émetteur couplé à la première borne de la diode de retour de spot (24), et en ce que le second amplificateur comporte un quatrième transistor (42) ayant une base couplée à la seconde sortie du préamplificateur (4), un émetteur relié au premier transistor (40) et un collecteur relié à la seconde alimentation en tension ($-V_2$), le troisième transistor (21) et le quatrième transistor (42) étant destiné à donner un fonctionnement symétrique en mode linéaire d'écriture vectorielle.

3. Ensemble selon l'une des revendications 1 et 2, caractérisé en ce que le préamplificateur comporte un amplificateur différentiel (4) ayant une première et une seconde entrée, la première entrée étant commandée par le signal de balayage et par un signal d'écriture de caractère créé indépendamment, et comprenant en outre une impédance (70) montée en série avec la bobine (73) de déviation afin qu'elle crée une tension représentatif du courant qui y circule et destinée à être renvoyée vers la seconde entrée de l'amplificateur différentiel afin qu'elle soit comparée au signal de balayage d'entrée et qu'un signal d'erreur égal à la différence entre les signaux d'entrée et de réaction soit formé et utilisé pour la commande du courant transmis par le préamplificateur en mode linéaire.

4. Ensemble selon la revendication 2 et toute revendication qui en dépend, caractérisé en ce que le troisième et le quatrième transistor (21, 42) sont choisis afin qu'ils soient symétriques et complémentaires, la première et la troisième alimentation en tension ($+V_2$, $+V_2$) a une polarité positive, et la seconde alimentation en tension ($-V_2$) a une polarité négative.

**Patentansprüche**

1. Horizontal-Ablenksteuersystem für eine Kathodenstrahlröhre, mit einer Ablenkspuleneinrichtung (73) und einem mit der Ablenkspuleneinrichtung gekoppelten Rücklaufkondensatorelement (28), mit einer Vorverstärkereinrichtung (4) mit einem Eingangsanschluß und ersten und zweiten Ausgangsanschlüssen, mit einer ersten Verstärkereinrichtung (21) mit Eingangs- und Ausgangsanschlüssen, wobei einer der Ausgangsanschlüsse mit einer ersten Spannungsversorgungseinrichtung ($+V_1$) gekoppelt ist, während der Eingangsanschluß mit dem ersten Ausgangsanschluß des Vorverstärkers zum Verstärken des von diesem empfangenen Stromes angekoppelt ist, mit einer zweiten Verstärkereinrichtung (42) mit Eingangs- und Ausgangsanschlüssen, wobei einer der Ausgangsanschlüsse mit einer zweiten Spannungsversorgungseinrichtung (−V₂) gekoppelt ist, während der Eingangsanschluß mit dem zweiten Ausgangsanschluß des Vorverstärkers gekoppelt ist, um den hiervon empfangenen Strom zu verstärken, mit einem Rücklaufdiodenelement (24) mit ersten und zweiten Anschlüssen, von denen der erste Anschluß mit dem Ausgangsanschluß des ersten Verstärkers gekoppelt ist, um einen von dem Ausgangsanschluß des Verstärkers empfangenen Strom in einer Richtung zum zweiten Anschluß der Rücklaufdiode zu leiten, mit einem Diodenelement (26) mit ersten und zweiten Anschlüssen, von denen der erste Anschluß mit der ersten Spannungsversorgungseinrichtung gekoppelt ist, während der zweite Anschluß mit dem Ausgangsanschluß der ersten Verstärkereinrichtung gekoppelt ist, um Strom von dem zweiten Anschluß des Diodenelementes in einer Richtung an die erste Spannungsversorgungseinrichtung weiterzuleiten, wobei das Rücklaufkondensatorelement in Serienbeziehung mit dem Diodenelement (26) und in Nebenschlußbeziehung mit dem Rücklaufdiodenelement (24) geschaltet ist, wobei ferner das Kondensatorelement einen Anschluß aufweist, der direkt gemeinsam mit der Ablenkspuleneinrichtung und dem zweiten Anschluß des Rücklaufdiodenelementes zusammengeschaltet ist, und wobei das System lineare Strich-Schreib- und nichtlineare resonante Rücklauf-Betriebsarten aufweist, und mit Einrichtungen zur Zuführung eines Eingangsablenksignals (2), das eine gewünschte Bewegung des Strahls darstellt, an den Eingangsanschluß des Vorverstärkers (4) während der linearen Betriebsweise, dadurch gekennzeichnet, daß Schalteinrichtungen vorgesehen sind, die auf ein angelegtes Rücklauf-Ansteuersignal (3) ansprechen, um den Ausgangsanschluß des zweiten Verstärkers (42) mit dem zweiten Anschluß des Rücklaufdiodenelementes (24) in der linearen Betriebsart zu koppeln und um den Ausgangsanschluß des zweiten Verstärkers von dem Rücklaufdiodenelement in der darauffolgenden nichtlinearen Betriebsart zu entkoppeln, daß die Schalteinrichtung die Form eines ersten Feldeffekttransistors (40) mit Source-, Drain- and Gate-Elektroden (40c, 40a, 40d) aufweist, daß die Source-Elektrode (40c) mit dem Ausgang des zweiten Verstärkers (42) gekoppelt ist, während die Drain-Elektrode (40a) mit dem zweiten Anschluß der Rücklaufdiode (24) gekoppelt ist, daß weiterhin ein Transformator (57) mit Primär- und Sekundärwicklungen (58, 56) vorgesehen ist, daß eine erste Serienschaltung zwischen den Gate- und Source-Elektroden (40d, 40c) des ersten Transistors (40) angeschaltet ist und eine Zenerdiode (55) und die Sekundärwicklung (56) des Transformators (57) umfaßt, daß ein erster Widerstand (52) zwischen dem Verbindungspunkt der Gate-Elektrode (40d) mit der Zenerdiode (55) und einer dritten Leistungsversorgungseinrichtung (+V₂) angeschaltet ist, daß eine zweite Serienschaltung zwischen der dritten Leistungsversorgungseinrichtung (+V₂) und einem Erdanschluß angeschaltet ist und einen zweiten Widerstand (54), der zwischen der dritten Leistungsversorgungseinrichtung (+V₂) und der Transformator-Primärwicklung (58) eingeschaltet ist und einen zweiten Transistor (59) umfaßt, dessen Emitter mit dem Erdanschluß, dessen Kollektor mit der Transformator-Primärwicklung (58) und dessen Basis zum Empfang der Rücklauf-Ansteuerimpulse verbunden ist, so daß die Leitfähigkeit des ersten Transistorelementes (40) bei Anlegen der Rücklaufansteuerimpulse an das zweite Transistorelement (59) im wesentlichen beendet wird.

2. System nach Anspruch 1, dadurch gekennzeichnet, daß die erste Verstärkereinrichtung einen dritten Transistor (21) aufweist, dessen Basis mit dem ersten Ausgangsanschluß der Vorverstärkereinrichtung (4) verbunden ist, dessen Kollektor mit der ersten Spannungsversorgungseinrichtung (+V₁) verbunden ist und dessen Emitter mit dem ersten Anschluß des Rücklaufdiodenelementes (24) verbunden ist, und daß der zweite Verstärker einen vierten Transistor (42) aufweist, dessen Basis mit dem zweiten Ausgang des Vorverstärkers (4) verbunden ist, dessen Emitter mit dem ersten Transistor (40) verbunden ist und dessen Kollektor mit der zweiten Spannungsversorgungseinrichtung (−V₂) verbunden ist, wobei der dritte Transistor (21) und der vierte Transistor (42) in der linearen Strich-Schreibbetriebsart für einen Gegentaktbetrieb ausgebildet sind.

3. System nach Anspruch 1 oder 2, dadurch gekennzeichnet, daß die Vorverstärkereinrichtung einen Differenzverstärker (4) mit ersten und zweiten Eingängen aufweist, daß der erste Eingang auf das Ablenksignal und ein unabhängig erzeugtes Zeichenschreibsignal anspricht, daß eine Impedanz (70) in Serie mit der Ablenkspule (73) geschaltet ist, um eine Spannung zu erzeugen, die den durch die Impedanz fließenden Strom darstellt und die an den zweiten Eingang des Differenzverstärkers zurückgeführt wird, um mit dem Ablenksignaleingang verglichen zu werden, und um ein Fehlersignal abzuleiten, das gleich der Differenz zwischen den Eingangs- und Rückführungssignalen ist, um den von der Vorverstärkereinrichtung gelieferten Strom in der Linearbetriebsart zu steuern.

4. System nach Anspruch 2 und irgendeinem darauf rückbezogenen Anspruch, dadurch gekennzeichnet, daß die dritten und vierten Transistoren (21, 42) so ausgewählt sind, daß sie komplementär symmetrisch sind, daß die ersten und dritten Spannungsversorgungseinrichtungen (+V₁, +V₂) eine positive Polarität aufweisen, und daß die zweite Spannungsversorgungseinrichtung (−V₂) eine negative Polarität aufweist.

FIG.1.

SWEEP AND FLYBACK DRIVE PULSE GENERATOR

PRE. AMP.

POWER SUPPLY

SYSTEM VIDEO

0 049 590

FIG. 2a.

SWEEP GENERATOR OUTPUT

FIG. 2b.

DEFLECTION COIL SWEEP CURRENT

FIG. 2c.

FLYBACK DRIVE PULSE

FIG. 2d.

BLANKING PULSE

FIG. 2e.

VOLTAGE ACROSS DEFLECTION COIL